Europäisches Patentamt

European Patent Office

Office européen des brevets

(19)

(11) **EP 1 458 097 A1**

(12) **EUROPEAN PATENT APPLICATION**

(43) Date of publication:
**15.09.2004 Bulletin 2004/38**

(51) Int Cl.$^7$: **H03H 17/06**

(21) Application number: **03005534.7**

(22) Date of filing: **11.03.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(71) Applicant: **Sony International (Europe) GmbH
10785 Berlin (DE)**

(72) Inventor: **Wildhagen, Jens
c/o Stuttgart Technology Center
Hedelfinger Strasse 61 70327 Stuttgart (DE)**

(74) Representative: **Müller - Hoffmann & Partner
Patentanwälte,
Innere Wiener Strasse 17
81667 München (DE)**

(54) **Arbitrary sampling rate conversion**

(57)    The invention provides a FIR filter calculation unit adapted for determining filter coefficients for a fractional delay FIR filter. From the sample values of a prototype filter's oversampled impulse response, at least two different subsets are extracted. In order to obtain a FIR filter with a predefined fractional time delay, an interpolation between the sample values of said different subsets is performed. The FIR filter calculation unit according to the invention can be used in a sampling rate converter. According to a respective fractional time delay between an input sample and the corresponding output sample, a suitable FIR filter for delaying the input sample is calculated. Next, convolutions of the input data stream with the interpolated filter coefficients of the respective FIR filters are performed.

Figure 3

**Description**

The invention relates to a FIR filter calculation unit and to a method for calculating filter coefficients representing a FIR filter. Furthermore, the invention relates to a sampling rate converter and to a method for converting an input sampling rate into an output sampling rate.

Often the necessity arises to convert a digital signal from one sampling rate to another sampling rate. For different applications, for example digital audio signal processing, digital television, digital video processing, digital image processing, software radio, etc. different sampling rates are specified, and data must be transmitted between these applications.

In the article "Design of Digital Systems for Arbitrary Sampling Rate Conversion" by Gennaro Evangelista, EURASIP Signal Processing, a generalized model for a synchronous sampling rate conversion (ASRC) is presented. Using the mathematical description of the generalized model, two different realizations are deduced, and the computational expenditure in terms of required multiplications and storage for these realizations is derived and compared.

In U.S. Patent 5,907,295 "Audio Sample-Rate Conversion using a Linear-Interpolation Stage with a Multi-Tap Low-Pass Filter Requiring Reduced Coefficient Storage" by T. Lin, a two-stage sample-rate converter for performing arbitrary sample-rate conversion is described. The first stage of the sample rate down converter adjusts the sampling rate by Q0/P0, while the second stage further adjusts the sampling rate by Q1/P1. The first stage, which adjusts the sampling rate by Q0/P0, can be thought of as a linear interpolator stage which eliminates or adds several samples and smoothes the samples by linear interpolation over the remaining samples. The second stage is implemented as a FIR filter stage that adjusts the sampling rate by a ratio of Q1/P1, which is approximately but not exactly equal to Q/P.

In the article "Design of Fractional Delay Filters Using Convex Optimization" by W. Putnam and J. Smith, Proceedings of the IEEE Workshop on Applications of Signal Processing to Audio and Acoustics, New Paltz, NY, New York, Oct. 1997, IEEE Press, an optimization technique for designing FIR fractional delay filters is described. In this paper, the design of fractional delay filters is approached as a convex optimization problem, whereby a convex function is minimized subject to a number of convex constraints.

It is an object of the invention to provide a sampling rate conversion for arbitrary sampling rates, whereby both the storage requirements and the computational expenditure are kept small.

The object of the invention is solved by a FIR filter calculation unit according to claim 1, by a sampling rate converter according to claim 10, by a method for calculating filter coefficients according to claim 15, and by a method for converting an input signal according to claim 21. Preferred embodiments thereof are respectively defined in the following dependent sub-claims. Computer program products according to the present invention are defined in claims 28 to 30.

The invention provides a FIR filter calculation unit adapted for providing filter coefficients representing a FIR filter with a predefined fractional time delay. The FIR filter calculation unit comprises a memory for storing sample values of a prototype filter's oversampled impulse response, and extracting means for extracting at least two different subsets of said sample values. Furthermore, the FIR filter calculation unit comprises interpolation means for performing an interpolation, in accordance with the predefined fractional time delay, between said at least two different subsets of sample values, in order to derive a set of filter coefficients that represent a FIR filter corresponding to said predefined fractional time delay.

The starting point for the calculation of the FIR filter's filter coefficients is the impulse response of a prototype filter, which has been sampled with an oversampling rate that is much higher than the respective FIR filter's clock frequency. The sample values of the prototype filter's oversampled impulse response are stored in a memory. Because the sample values have been obtained by oversampling, the number of sample values is much higher than the required number of filter coefficients. This provides a certain freedom to select certain subsets of said sample values, whereby each subset can be used as a set of filter coefficients of a fractional delay FIR filter.

Because of the limited resolution of the oversampled impulse response, a more accurate interpolated set of filter coefficients is obtained by performing an interpolation between at least two different subsets of sample values of the prototype filter's oversampled impulse response. Thus, it is possible to obtain interpolated filter coefficients for a FIR filter that has exactly the required fractional time delay. By performing the interpolation in accordance with the predefined fractional time delay, the required accuracy in determining the filter coefficients can be reached. The invention is capable of providing a set of filter coefficients that exactly corresponds to a desired fractional time delay. The storage requirements are kept small, and the interpolation between the at least two subsets of sample values does not require too much calculation power.

According to a preferred embodiment of the invention, each of said subsets of sample values of the oversampled impulse response corresponds to a certain time delay value of a fractional delay FIR filter represented by said subset. The prototype filter's impulse response has been sampled with an oversampling rate that is far higher than a respective FIR filter's clock rate. For each filter clock cycle, there exist a multitude of sample values. A respective subset of said sample values can be obtained by extracting one sample values per filter clock cycle. When said subset is used as a set of filter coefficients for a FIR filter, a certain fractional time delay of said FIR filter will be obtained.

Preferably, in order to extract a subset of the sample values of the prototype filter's oversampled impulse response, said extracting means extract every k-th sample value of said oversampled impulse response. As an example, the oversampling rate might be 128 times faster than the filter clock rate. This means that k = 128, and therefore, every 128th sample value of the impulse response has to be extracted in order to obtain one of said subsets. One can for example select the sample values 3, 131, 259, 387, ... in order to obtain a first subset. For obtaining another subset, one might extract the sample values 10, 138, 266, ....

Preferably, the prototype filter's oversampled impulse response is a low-pass filter's impulse response. In this case, the FIR filters represented by subsets of sample values of the oversampled impulse response will also exhibit some low-pass filtering capability. This is advantageous, because it helps to suppress aliasing effects.

Preferably, said extracting means extract at least a first subset of sample values that corresponds to a first time delay that is smaller than the predefined fractional time delay, and a second subset of sample values that corresponds to a second time delay that is larger than the predefined fractional time delay. The multitude of possible subsets of sample values corresponds to a multitude of possible time delays. From these time delays, a first time delay that is slightly below the predefined fractional time delay, and a second time delay that is slightly above the predefined fractional time delay are selected. The predefined fractional time delay lies between the two time delays, and the interpolation can be carried out with high accuracy. Therefore, extracting two subsets of sample values is sufficient for obtaining good results.

According to a preferred embodiment of the invention, said interpolation means perform a linear interpolation between the sample values of the first subset and the sample values of the second subset, whereby the interpolation is carried out in accordance with the first time delay corresponding to the first subset, the predefined fractional time delay, and the second time delay corresponding to the second subset. In dependence on the relative position of the predefined fractional time delay relative to the first and the second time delay, a linear interpolation between the sample values of the first and the second subset is performed.

Preferably, said sample values of the prototype filter's oversampled impulse response are stored, as a look-up table, in a RAM or a ROM. A ROM is cheap, and the required area on a chip is small. On the other hand, when a RAM is employed, a memory access only takes one clock cycle in most digital signal processors.

According to another preferred embodiment of the invention, the access of the memory and the interpolation are at least partly performed in parallel. For extracting the subset of sample values required for the interpolation, memory accesses have to be performed, whereby each memory access takes one or two clock cycles. While the memory is accessed, calculations required for the interpolation procedure can be carried out, for example by means of a MAC (Multiplier/Accumulator) on a DSP.

Preferably, the prototype filter's oversampled impulse response has been sampled with an oversampling rate that is a multiple of the output sample rate. Usually, the FIR filter is clocked by the output sample rate.

Furthermore, the invention provides a sampling rate converter adapted for receiving an input signal with an input sample rate, and for converting said input signal into an output signal with an output sample rate. The sampling rate converter comprises a delay determination unit for individually determining, for each of the output samples, a respective fractional time delay between said output sample and a corresponding input sample of the input signal. Furthermore, the sampling rate converter comprises a FIR filter calculation unit as described above. The FIR filter calculation unit provides, individually for each of the output samples, a set of filter coefficients that represent a FIR filter adapted for delaying the corresponding input sample by the respective fractional time delay. The sampling rate converter further comprises convolution means for convoluting, individually for each of the output samples, the sequence of input samples with the filter coefficients provided by the FIR filter calculation unit, in order to obtain a sequence of output samples.

The FIR filter calculation unit as described above can be used for realizing a sampling rate converter. In order to convert an input signal having an input sample rate into an output signal with a different output sample rate, respective fractional time delays between corresponding pairs of input and output samples are determined. An obtained fractional delay value is forwarded to a FIR filter calculation unit according to the invention, and there, a fractional delay FIR filter having exactly the required delay is determined, and a set of FIR filter coefficients is obtained. In order to generate one output sample, the sequence of input samples has to be convoluted with the filter coefficients that correspond to the required time delay. For each output sample to be generated, a individual convolution has to be carried out. Each convolution delivers one output sample. By starting the respective convolutions at adequate start samples of the input data stream, a sequence of output samples having the desired output sample rate is obtained.

Because the required filter coefficients are provided by means of interpolation, the storage size can be kept small. The calculational load, which is mainly caused by the interpolation procedure and by the convolutions, is not too large either.

Preferably, at least two different sequences of input samples are convoluted in parallel with the filter coefficients provided by the FIR filter calculation unit. The use of a sampling rate converter according to the invention is especially advantageous when several input signals with an input sample rate FS1 have to be converted into corresponding output signals having an output sample rate FS2. In this case, the input samples of the various input data streams are received synchronously, and also the output samples of the corresponding output data streams have to be generated synchronously. For this reason, the same fractional delay FIR filters are required for all the input data streams. The respectively required interpolated filter coefficients only have to be calculated once. Then, all the input streams are convoluted in parallel with said interpolated filter coefficients. Compared to prior art solutions, for example as described in U.S. Patent 5,907,295, the computational expenditure is considerably reduced.

Preferably, the sampling rate converter comprises a control unit adapted for determining, individually for each output sample, a corresponding input sample where the convolution of the sequence of input samples with the filter coefficients is started. The control unit keeps track of the respectively required time delays between an input sample and a corresponding output sample, and selects the start sample for starting the convolution accordingly. For example, the start sample of the input data stream might be determined in accordance with the integral part of the respectively required time delay.

According to a preferred embodiment of the invention, the sampling rate of a received signal, in particular of a received audio signal, is converted into a receiver's internal clock rate. In this embodiment, the sampling rate converter is used for synchronizing a received signal to the receiver's internal clock rate, which might be slightly different from the sampling rate of the received signal. Instead of adjusting the receiver's internal clock rate, e.g. by means of a voltage controlled oscillator (VCXO), a sampling rate converter according to the invention might be used.

In the following, the invention will be described in more detail taking reference to the accompanying figures on the basis of preferred embodiments of the invention.

**Fig. 1** shows a block diagram of a FIR filter;

**Fig. 2** depicts a prototype filter's oversampled impulse response;

**Fig. 3** shows how subsets of the sample values of the oversampled impulse response are extracted in accordance with the required fractional time delay;

**Fig. 4** is a block diagram of a sampling rate converter according to the invention;

**Fig. 5A** shows how the start samples for the convolution of the input data stream are selected in case the sampling rate is up-converted; and

**Fig. 5B** shows how the start samples for the convolution are selected in case the sampling rate is down-converted.

First, a technique for designing fractional delay filters for arbitrary fractional delays will be described. Fractional delay filters exhibit unity magnitude response and a flat group delay. Designing fractional delay filters involves determining the coefficients of a FIR (Finite Impulse Response) filter in a way that its response best approximates the complex valued frequency response of the desired fractional delay.

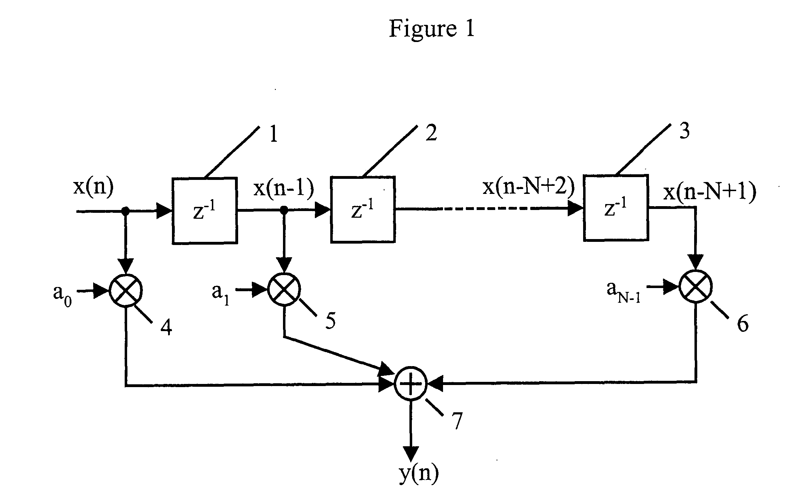

Fig. 1 shows the most general implementation of a FIR filter, which might for example be realized by means of a DSP (Digital Signal Processor). On the left side of Fig. 1, a digital input signal is provided to the FIR filter. The FIR filter is operated with a filter clock rate $f_{filter}$, and in accordance with this frequency $f_{filter}$, the digital input values $x(n)$ are clocked through a chain of storage cells 1, 2, ..., 3. Whenever a rising edge of the filter clock occurs, the most recent digital value $x(n)$ is written into the first storage cell 1, the digital value $x(n-1)$ is written into the second storage cell 2, etc.. Thus, the digital values $x(n)$ are shifted through the chain of storage cells 1, 2, ..., 3 in accordance with the filter's clock rate $f_{filter}$. At each instant of time, the chain of storage cells contains the N most recent digital values $x(n)$, $x(n-1)$, ..., $x(n-N+1)$ of the input signal. Next, each of the N most recent digital values is multiplied with a corresponding filter coefficient $a_0$, $a_1$, ..., $a_{N-1}$. For this purpose, the FIR filter comprises a set of N multipliers 4, 5, ..., 6. The output values of said N multipliers 4, 5, ..., 6 are provided to an adder 7, and at the output of said adder, the filter's digital output signal $y(n)$ is obtained. The output values $y(n)$ can be expressed as a function of the N most recent input values as follows:

$$y(n) = \sum_{i=0}^{N-1} a_i \cdot x(n - i)$$

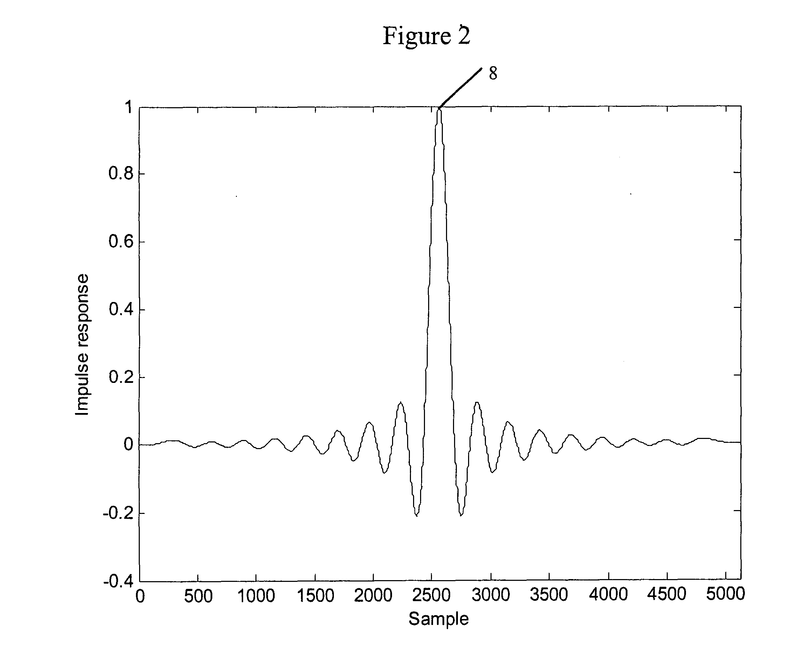

The task is to determine the N filter coefficients $a_0$, $a_1$, ..., $a_{N-1}$ for a given fractional delay $\Delta\tau$. According to the invention, the set of filter coefficients is derived from an oversampled impulse response of a prototype filter, preferably of a low pass filter. The digitized impulse response, which has been sampled with an oversampling rate fos, is shown in Fig. 2. The oversampling rate fos is an integral multiple of the filter's clock rate $f_{filter}$:

$$f_{OS} = k \cdot f_{filter}$$

In the example shown in Fig. 2, k = 128, and therefore, the 5120 sample values of the impulse response shown in Fig. 2 have been recorded during N = 40 clock cycles of the filter clock. In the following, $\Delta t = \dfrac{1}{f_{OS}}$ shall denote one period of the oversampling rate, and $T = \dfrac{1}{f_{filter}}$ shall denote one period of the filter clock.

Therefore, there exist k = 128 sample values of the prototype filter's impulse response per filter clock period T.

According to the invention, the sample values of the impulse response shown in Fig. 2 are used for deriving a set of filter coefficients for a fractional delay FIR filter. In order to generate an impulse response with a defined group delay, a subset of the 5120 sample values of the prototype filter's oversampled impulse response is extracted. Said subset of sample values is provided, as a set of filter coefficients $a_0$, $a_1$, ..., $a_{N-1}$, to a FIR filter as shown in Fig. 1.

The prototype filter's impulse response has been sampled during a time interval of N = 40 clock cycles of the filter clock, whereby during each clock cycle of the filter clock, 128 sample values have been recorded. Now, from each group of k = 128 sample values, one filter coefficient is derived, in a way that N = 40 filter coefficients $a_0$, $a_1$, ..., $a_{39}$ are derived from the 128 x 40 = 5120 sample values of the prototype filter's oversampled impulse response.

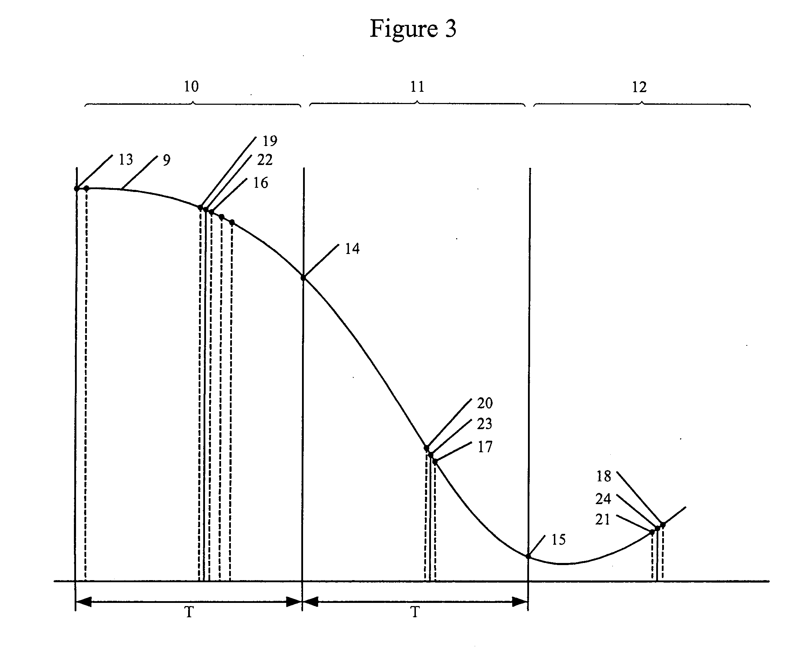

In Fig. 3, the various groups of sample values of the oversampled impulse response 9 are shown. From the first group 10 comprising 128 sample values, the filter coefficient $a_0$ is obtained. From the second group 11, which comprises the next 128 sample values, the filter coefficient $a_1$ is obtained, and from the subsequent group 12, the filter coefficient $a_2$ is obtained.

In order to understand how a subset of filter coefficients can be derived from the oversampled impulse response shown in Fig. 3, several examples will be discussed. According to a first example, one might select the respectively first sample value 13, 14, 15, ... of each of the groups 10, 11, 12, ... as a filter coefficient. In this example, the filter coefficient $a_0$ is set to the sample value 13, the filter coefficient $a_1$ is set to the sample value 14, and the filter coefficient $a_2$ is set to the sample value 15. A FIR filter with 40 filter coefficients is obtained, whereby the group delay of this FIR filter corresponds to the position of the peak 8 of the oversampled impulse response shown in Fig. 2. As can be seen in Fig. 2, this peak occurs approximately after 2560 samples, which corresponds to approximately 20 clock cycles. Therefore, the obtained FIR filter will have a group delay of approximately 20 clock cycles of the corresponding filter clock, and the coefficient $a_{20}$ will have a rather large value.

According to a second example, instead of selecting the sample values 13, 14, 15, ... of each group, the respectively 64th sample value 16, 17, 18, ... of each group is selected as a respective filter coefficient $a_0$, $a_1$, $a_2$, ... of the FIR filter. By shifting the selected sample values to the right, the filter's fractional delay is decreased, because effectively, the peak 8 of the prototype filter's impulse response is shifted to the left. In this example, where the respectively 64th sample values have been selected as a respective filter coefficients, a group delay of 19.5 clock periods of the filter clock is obtained.

According to the third example, it is assumed that instead of the respective 64th sample values of the groups 10, 11, 12, ..., the respective 63rd sample values 19, 20, 21, ... are selected as filter coefficients $a_0$, $a_1$, $a_2$, .... Compared to the sample values 16, 17, 18, ..., the sample values 19, 20, 21, ... have been shifted to the left, and therefore, the FIR filter's fractional time delay is increased. The time resolution $\Delta t$ shown in Fig. 3 is determined by the oversampling rate fos, and therefore,

$$\Delta t = \frac{1}{k} \cdot T = \frac{1}{128} \cdot T$$

For this reason, the sample values 19, 20, 21, ... represent a FIR filter having a fractional delay of (19.5 + 1/128) = 19.5078 clock cycles of the filter clock.

The fractional delay $\Delta\tau$ of the FIR filter can only be varied in steps of 1 / 128 of the filter's clock period, which is a rather coarse time resolution. Of course, one could increase the oversampling rate $f_{os}$, but this would lead to a considerable increase of the number k x N of sample values of the prototype filter's impulse response, and thus to a considerable increase of the required storage space.

According to the invention, the time resolution is improved by performing an interpolation, preferably a linear interpolation, between adjacent sample values of the prototype filter's oversampled impulse response. This interpolation technique allows to calculate a set of filter coefficients $a_0$, $a_1$, ..., $a_{N-1}$ for a FIR filter with any desired fractional delay. According to a fourth example, a FIR filter with a fractional delay of 19.505 clock cycles is realized. The subset of sample values 16, 17, 18, ... corresponds to a fractional delay of 19.500 clock cycles, and the adjacent subset of sample values 19, 20, 21, ... corresponds to a fractional delay of 19.5078 clock cycles of the filter clock. Therefore, by performing a linear interpolation between said two subsets of sample values, interpolated sample values 22, 23, 24, ... are obtained, which can be used as filter coefficients $a_0$, $a_1$, $a_2$, ... for a FIR filter with a fractional delay of 19.505. The fractional portion $\Delta\tau$ of the time delay is also shown in Fig. 3.

The sample values of the prototype filter's oversampled impulse response can be kept in a look-up table, which can either be stored in a RAM or a ROM. A ROM might be preferable, because it is cheaper and smaller than a RAM. On the other hand, a RAM access usually takes one clock cycle, while a ROM access usually takes two clock cycles. The performance of the FIR filter calculation unit can be further increased by performing the respective memory accesses and the interpolation in parallel. A typical digital signal processor (DSP) might comprise an arithmetic unit (MAC) that may perform the interpolations while the memory is accessed.

Next, it will be described how the FIR filter calculation unit as described above can be employed in an arbitrary sampling rate converter. A sampling rate converter receives an input signal having an input sample rate and converts said input signal into an output signal with a different output sample rate. According to the invention, each of the received input samples is delayed by an individually calculated time delay, in order to obtain a corresponding output sample. First, the required time delay $\tau$ between an input sample and a corresponding output sample is calculated. Then, a set of filter coefficients $a_0$, $a_1$, ..., $a_{N-1}$ is individually calculated for the required time delay $\tau$ between the input sample and the output sample. In order to determine the set of filter coefficients, the above mentioned technique is used. In order to obtain a sequence of output samples, the received sequence of input samples is convoluted, individually for each required output sample, with a corresponding sequence of filter coefficients. The above described technique for calculating a set of filter coefficients is sufficiently fast for providing one set of filter coefficients per output sample.

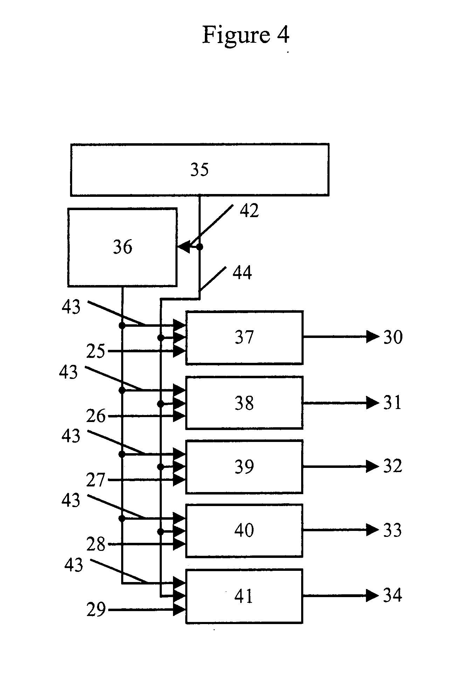

In Fig. 4, a block diagram of a sampling rate converter is shown. Five different input signals 25 to 29 with an input sample rate FS1 are received and converted into a corresponding set of five output signals 30 to 34. The set of input signals 25 to 29 might for example be a set of five audio signals comprising a front left signal 25, a front right signal 26, a center signal 27, a rear left signal 28 and a rear right signal 29. Accordingly, the corresponding set of five output signals might comprise a front left signal 30, a front right signal 31, a center signal 32, a rear left signal 33, and a rear right signal 34. The set of input signals 25 to 29 might e.g. be an ensemble of audio signals that is received by a digital broadcast receiver, e.g. by a DAB receiver. The sampling rate converter comprises a rate converter control 35 for controlling a FIR filter calculation unit 36 and a set of convolution blocks 37 to 41. In dependence on the ratio of the input sample rate FS1 to the output sample rate FS2, the rate converter control 35 determines, individually for each of the output samples, a corresponding fractional time delay between said output sample and a corresponding input sample. These fractional time delays 42 are provided to the FIR filter calculation unit 36, and there, a set of filter coefficients corresponding to the respectively required fractional time delay 42 is calculated. The derived set of filter coefficients 43 is provided to each of the convolution blocks 37 to 41. For each output sample to be generated, a convolution is performed by the respective convolution block.

The sequences of filter coefficients 43 have to be correctly aligned with the stream of input samples. For this purpose, the rate converter control 35 transmits a control signal 44 to each of the convolution blocks 37 to 41, with said control signal 44 indicating the respective start sample where the convolution has to be started. These start samples can be determined from the time delay between an input sample and its corresponding output sample.

In the example of Fig. 4, all the input signals 25 to 29 have the same input sample rate FS1. Also the output sample rate FS2 is identical for all the output signals 30 to 34. Therefore, the input streams of the five input signals 25 to 29 have to be treated in an identical manner. A respective set of filter coefficients 43 is therefore provided to all the convolution blocks 37 to 41 in parallel.

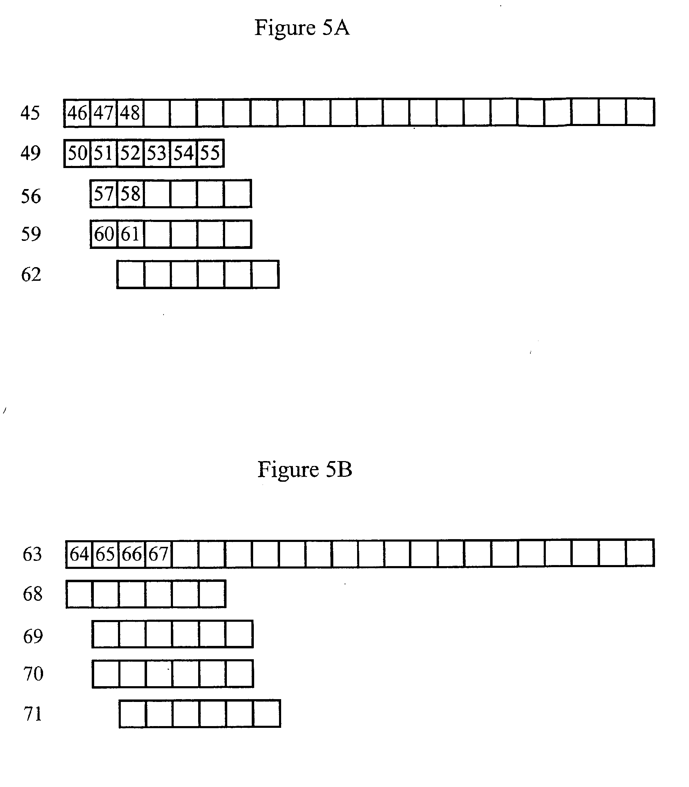

In Fig. 5A, it is shown how the convolution is performed in case the output sample rate FS2 is larger than the input sample rate FS1: FS2 > FS1. In this case, the output samples of the output signal have to occur more frequently than the input samples of the input signal. The input signal 45 in the upper part of Fig. 5A comprises a sequence of input samples 46, 47, 48, .... In order to generate a first output sample of the output signal, a subset of the input samples is convoluted with a set 49 of filter coefficients 50 to 55, whereby the convolution is started at the input sample 46. The filter coefficients 50 to 55 have been calculated in accordance with the fractional time delay required for generating a first output sample. For the sake of simplification, sets of filter coefficients comprising as few as six filter coefficients are shown. A more realistic set would comprise a much larger number of filter coefficients. For generating a second output sample, a sequence of six input samples, starting at the input sample 47, is convoluted with the set 56 of filter coefficients. The set 56 of filter coefficients has been calculated in accordance with the fractional time delay required for generating a respective second output sample. The filter coefficients 57, 58, ... are therefore not identical to the filter coefficients 50 to 55.

Because of the rather large output sample rate, the time intervals between consecutive output samples are shorter than the time intervals between consecutive input samples. From time to time, it might therefore be necessary to start two consecutive convolutions at the same input sample. For generating the third output sample, the input samples 47, 48, ... are convoluted with the set 59 of filter coefficients 60, 61, .... The thus generated third output sample does not coincide with the second output sample, though, because the filter coefficients 60, 61, ... correspond to a different fractional delay than the filter coefficients 57, 58, .... A fourth set 62 of filter coefficients is used for generating a fourth output sample.

Fig. 5B shows the case of an output sample rate FS2 that is smaller than the input sample rate FS1: FS2 < FS1. Again, a sequence 63 of input samples 64, 65, 66, 67, ... is convoluted with different sets 68, 69, 70, 71 of filter coefficients, in order to obtain a respective sequence of output samples. The first convolution is started at the input sample 64, and the second convolution is started at the input sample 65. Then, due to the rather low sample rate of the output signal, it is necessary to skip one input sample, the input sample 66. Therefore, the convolution for calculating the third output sample is started at the input sample 67.

**List of Reference Symbols**

| | |
|---|---|
| **1,2,3** | storage cells |
| **4,5,6** | multipliers |
| **7** | adder |
| **8** | peak of the oversampled impulse response |
| **9** | oversampled impulse response |
| **10** | first group of sample values |
| **11** | second group of sample values |
| **12** | third group of sample values |
| **13,14,15** | first sample values |
| **16,17,18** | respectively 64th sample values |
| **19,20,21** | respectively 63rd sample values |
| **22,23,24** | interpolated sample values |
| **25-29** | five input signals |
| **30-34** | five output signals |
| **35** | rate converter control |
| **36** | FIR filter calculation unit |
| **37-41** | convolution blocks |
| **42** | fractional time delay |
| **43** | set of filter coefficients |
| **44** | control signal |
| **45** | input signal |
| **46,47,48** | input samples |
| **49** | set of filter coefficients |
| **50-55** | filter coefficients |
| **56** | set of filter coefficients |
| **57,58** | filter coefficients |
| **59** | set of filter coefficients |
| **60,61** | filter coefficients |
| **62** | set of filter coefficients |
| **63** | sequence of input samples |
| **64-67** | input samples |
| **68-71** | sets of filter coefficients |

**Claims**

1. FIR filter calculation unit adapted for providing filter coefficients representing a FIR filter with a predefined fractional time delay, comprising:

 - a memory adapted for storing sample values of a prototype filter's oversampled impulse response (9);
 - extracting means adapted for extracting at least two different subsets (16-18, 19-21) of said sample values;
 - interpolation means adapted for performing an interpolation, in accordance with the predefined fractional time delay, between said at least two different subsets (16-18, 19-21) of sample values, in order to derive a set of filter coefficients that represent a FIR filter corresponding to said predefined fractional time delay.

2. FIR filter calculation unit according to claim 1, wherein each of said subsets (16-18, 19-21) of sample values of the oversampled impulse response (9) is adapted to correspond to a certain time delay value of a fractional delay FIR filter represented by said subset.

3. FIR filter calculation unit according to any one of the preceding claims, wherein in order to extract a subset (16-18) of the sample values of the prototype filter's oversampled impulse response (9), said extracting means is adapted to extract every k-th sample value of said oversampled impulse response (9).

4. FIR filter calculation unit according to any one of the preceding claims, wherein said prototype filter's oversampled impulse response (9) is a low pass filter's impulse response.

5. FIR filter calculation unit according to any one of the preceding claims, wherein said extracting means are adapted to extract at least a first subset (16-18) of sample values that corresponds to a first time delay that is smaller than the predefined fractional time delay, and a second subset (19-21) of sample values that corresponds to a second time delay that is larger than the predefined fractional time delay.

6. FIR filter calculation unit according to claim 5, wherein said interpolation means are adapted to perform a linear interpolation between the sample values of the first subset (16-18) and the sample values of the second subset (19-21), whereby the interpolation is carried out in accordance with the first time delay corresponding to the first subset (16-18), the predefined fractional time delay, and the second time delay corresponding to the second subset (19-21).

7. FIR filter calculation unit according to any one of the preceding claims, wherein said sample values of the prototype filter's oversampled impulse response (9) are stored or storable, in particular as a look-up table, in a RAM or a ROM.

**8.** FIR filter calculation unit according to any one of the preceding claims,
   wherein the access of the memory and the interpolation are at least partly performed or performable in parallel.

**9.** FIR filter calculation unit according to any one of the preceding claims,
   wherein the prototype filter's oversampled impulse response (9) has been sampled with an oversampling rate that is a multiple of the output sampling rate.

**10.** Sampling rate converter adapted for receiving an input signal with an input sample rate, and for converting said input signal into an output signal with an output sample rate, comprising:

   - a delay determination unit (35) adapted for individually determining, for each of the output samples, a respective fractional time delay between said output sample and a corresponding input sample of the input signal;
   - a FIR filter calculation unit (36) according to any one of claims 1 to 10, adapted to provide, individually for each of the output samples, a set of filter coefficients that represent a FIR filter adapted for delaying the corresponding input sample by the respective fractional time delay;
   - convolution means (37-41) adapted for convoluting, individually for each of the output samples, the sequence of input samples with the filter coefficients provided by the FIR filter calculation unit (36), in order to obtain a sequence of output samples.

**11.** Sampling rate converter according to claim 10,
   wherein at least two different sequences of input samples are convoluted in parallel with the filter coefficients provided by the FIR filter calculation unit (36).

**12.** Sampling rate converter according to claim 10 or claim 11,
   comprising a control unit (35) adapted for determining, individually for each output sample, a corresponding input sample where the convolution of the sequence of input samples with the filter coefficients is started.

**13.** Sampling rate converter according to any of claims 10 to 12,
   wherein the prototype filter's oversampled impulse response (9) has been sampled with an oversampling rate that is a multiple of the output sample rate.

**14.** Sampling rate converter according to any of claims 10 to 13,
   wherein the sample rate of a received signal, in particular of a received audio signal, is convertable or converted into a receiver's internal clock rate.

**15.** Method for calculating filter coefficients representing a FIR filter with a predefined fractional time delay,
   comprising the steps of

   - extracting at least two different subsets (16-18, 19-21) of sample values of a prototype filter's oversampled impulse response (9);
   - performing an interpolation, in accordance with the predefined time delay, between said at least two different subsets (16-18, 19-21) of sample values, in order to derive a set of filter coefficients that represent a FIR filter corresponding to the predefined fractional time delay.

**16.** Method according to claim 15,
   wherein each of said subsets (16-18, 19-21) of sample values of the oversampled impulse response (9) corresponds to a certain time delay value of a fractional delay FIR filter represented by said subset.

**17.** Method according to claim 15 or claim 16,
   wherein a subset (16-18) of the sample values of the prototype filter's oversampled impulse response (9) is extracted by selecting every k-th sample value of said oversampled impulse response (9).

**18.** Method according to any of claims 15 to 17,
   comprsing a step of extracting at least a first subset (16-18) of sample values that corresponds to a first time delay that is smaller than the predefined fractional time delay, and
   compising a step of extracting a second subset (19-21) of sample values that corresponds to a second time delay that is larger than the predefined fractional time delay.

**19.** Method according to claim 18,
   comprising a step of performing a linear interpolation between the sample values of the first subset (16-18) and the sample values of the second subset (19-21), whereby the interpolation is carried out in accordance with the first time delay corresponding to the first subset (16-18), the predefined fractional time delay, and the second time delay corresponding to the second subset (19-21).

**20.** Method according to any of claims 15 to 19,
   wherein the extraction of a subset (16-18) of sample values and the interpolation are at least partly performed in parallel.

21. Method for converting an input signal with an input sample rate into an output signal with an output sample rate,
comprising the following steps:

   - determining, individually for each of the output samples, a respective fractional time delay between an output sample and a corresponding input sample of the input signal;
   - extracting, for each of the respective fractional time delays, at least two different subsets (16-18, 19-21) of sample values of a prototype filter's oversampled impulse response (9);
   - performing an interpolation between said at least two different subsets (16-18, 19-21) of sample values, in accordance with the respective fractional time delay, individually for each of the output samples, in order to derive a set of filter coefficients that represent a FIR filter corresponding to the respective fractional time delay;
   - performing a convolution, individually for each of the output samples, of the sequence of input samples and the filter coefficients, in order to obtain a sequence of output samples.

22. Method according to claim 21,
comprising a step of determining, individually for each output sample, a corresponding input sample where the convolution of the sequence of input samples with the filter coefficients is started.

23. Method according to claim 21 or claim 22,
wherein each of said subsets (16-18, 19-21) of sample values of the oversampled impulse response (9) corresponds to a certain time delay value of a fractional delay FIR filter represented by said subset.

24. Method according to any of claims 21 to 23,
wherein a subset (16-18) of the sample values of the prototype filter's oversampled impulse response (9) is extracted by selecting every k-th sample value of said oversampled impulse response (9).

25. Method according to any of claims 21 to 24,
wherein the extraction of a subset (16-18) of sample values and the interpolation are at least partly performed in parallel.

26. Method according to any of claims 21 to 25,
wherein at least two different sequences of input samples are convoluted in parallel with the filter coefficients.

27. Method according to any of claims 21 to 26,
comprising a step of converting the sample rate of a received signal, in particular of a received audio signal, into a receiver's internal clock rate.

28. Computer program product, comprising computer program means adapted to embody the features of the FIR filter calculation unit (36) as defined in anyone of claims 1 to 9 when said computer program product is executed on a computer, digital signal processor, or the like.

29. Computer program product, comprising computer program means adapted to embody the features of the sampling rate converter as defined in anyone of claims 10 to 14, when said computer program product is executed on a computer, digital signal processor, or the like.

30. Computer program product, comprising computer program means adapted to perform the method steps as defined in anyone of claims 15 to 27 when said computer program product is executed on a computer, digital signal processor, or the like.

Figure 1

EP 1 458 097 A1

Figure 2

EP 1 458 097 A1

Figure 3

EP 1 458 097 A1

Figure 4

Figure 5A

Figure 5B

European Patent
Office

**EUROPEAN SEARCH REPORT**

Application Number

EP 03 00 5534

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | J.O.SMITH AND P. GOSSET: "A flexible sampling-rate conversion method" PROCEEDINGS OF THE INTERNATIONAL CONFERENCE ON AOUSTICS, SPEECH, AND SIGNAL PROCESSING, vol. 2, 1984, pages 19.4.1-19.4.4, XP002252162 New York * figure 2 * * abstract * * page 19.4.1, left-hand column, line 38 - right-hand column, line 4 * * page 19.4.2, left-hand column, line 6-11,14-18 * | 1-30 | H03H17/06 |
| X | T.I.LAAKSO, V.VÄLIMÄKI, M.KARJALAINEN, U.K.LAINE: "Splitting the Unit Delay" IEEE SIGNAL PROCESSING MAGAZINE, 1996, pages 30-60, XP002252163 * figures 1-3 * * abstract * * page 31, right-hand column, line 15 - page 33, right-hand column, line 21 * * page 46, right-hand column, line 16-20 * * page 44, left-hand column, line 13 - page 45, right-hand column, line 19 * | 1,2,15, 16 | |
| A | EP 1 160 979 A (TEXAS INSTRUMENTS INC) 5 December 2001 (2001-12-05) * figures 1-10 * * abstract * * page 2, line 30-34 * | 1-30 | TECHNICAL FIELDS SEARCHED (Int.Cl.7) H03H |
| A | WO 99 60701 A (UNIV DELFT TECH ;COENEN ANTONIUS JOHANNES ROBER (NL)) 25 November 1999 (1999-11-25) * figure 1 * * abstract * | 1-30 | |

-/--

The present search report has been drawn up for all claims

| Place of search | Date of completion of the search | Examiner |
|---|---|---|
| MUNICH | 22 August 2003 | Plathner, B-D |

EP 1 458 097 A1

**European Patent Office**

## EUROPEAN SEARCH REPORT

Application Number

EP 03 00 5534

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 599 817 A (SONY CORP) 1 June 1994 (1994-06-01) * figure 13 * * abstract * ----- | 1-30 | |
| | | | **TECHNICAL FIELDS SEARCHED** (Int.Cl.7) |

The present search report has been drawn up for all claims

| Place of search | Date of completion of the search | Examiner |
|---|---|---|
| MUNICH | 22 August 2003 | Plathner, B-D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

16

**ANNEX TO THE EUROPEAN SEARCH REPORT
ON EUROPEAN PATENT APPLICATION NO.**                    EP 03 00 5534

This annex lists the patent family members relating to the patent documents cited in  the above-mentioned European search report.
The members are as contained in the European Patent Office EDP file on
The European Patent Office is in no way liable for these particulars which are merely  given for the purpose of information.

22-08-2003

| Patent document cited in search report | | Publication date | Patent family member(s) | | Publication date |
|---|---|---|---|---|---|
| EP 1160979 | A | 05-12-2001 | EP | 1160979 A2 | 05-12-2001 |
|  |  |  | JP | 2002026690 A | 25-01-2002 |
|  |  |  | US | 2002046227 A1 | 18-04-2002 |
| WO 9960701 | A | 25-11-1999 | NL | 1009198 C2 | 19-11-1999 |
|  |  |  | AU | 3854199 A | 06-12-1999 |
|  |  |  | WO | 9960701 A1 | 25-11-1999 |
| EP 0599817 | A | 01-06-1994 | JP | 1175310 A | 11-07-1989 |
|  |  |  | JP | 2600236 B2 | 16-04-1997 |
|  |  |  | EP | 0599817 A1 | 01-06-1994 |
|  |  |  | DE | 3853669 D1 | 01-06-1995 |
|  |  |  | DE | 3853669 T2 | 31-08-1995 |
|  |  |  | DE | 3856142 D1 | 09-04-1998 |
|  |  |  | DE | 3856142 T2 | 02-07-1998 |
|  |  |  | EP | 0323200 A2 | 05-07-1989 |
|  |  |  | US | 4953117 A | 28-08-1990 |

EPO FORM P0459

For more details about this annex : see Official Journal of the European Patent Office, No. 12/82